Europäisches Patentamt

European Patent Office

Office européen des brevets

(19)

(11) **EP 1 187 311 A1**

(12) ## DEMANDE DE BREVET EUROPEEN

(43) Date de publication:
**13.03.2002 Bulletin 2002/11**

(51) Int Cl.⁷: **H03F 1/32**, H03F 3/60, H03F 3/68

(21) Numéro de dépôt: **01203280.1**

(22) Date de dépôt: **31.08.2001**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **12.09.2000 FR 0011590**

(71) Demandeur: **Koninklijke Philips Electronics N.V.**
**5621 BA Eindhoven (NL)**

(72) Inventeurs:
• **Constantinidis, Nicolas**
 **75008 Paris (FR)**
• **Crinon, Guillaume**
 **75008 Paris (FR)**

(74) Mandataire: **Chaffraix, Jean**
 **Société Civile S.P.I.D.**
 **156, Boulevard Haussmann**
 **75008 Paris (FR)**

(54) **Dispositif d'amplification à linéarité optimisée.**

(57) La présente invention concerne un dispositif d'amplification AD, incluant un premier et un deuxième amplificateur AMP1 et AMP2 disposés en cascade chacun étant muni d'une boucle de rétro-action Zi (pour i=1 ou 2) et possédant un gain propre Gi égal à Ai/(1+Ai.Zi).

Selon l'invention, la valeur de l'inverse du gain propre G1 du premier amplificateur AMP1 est substantiellement égale au triple de la valeur de l'inverse du gain propre G2 du deuxième amplificateur AMP2 portée au cube : $(1/G1) = 3/(G2)^3$.

Un tel choix confère au dispositif d'amplification AD une linéarité optimale.

Application : Amplification de signaux audio ou vidéo.

FIG.1

EP 1 187 311 A1

## Description

La présente invention concerne un dispositif d'amplification incluant un premier et un deuxième amplificateur disposés en cascade, chacun possédant un gain propre et étant muni d'une boucle de rétro-action.

Un tel dispositif est décrit à la page 223 du manuel «Design with Operational Amplifiers and Analog Integrated Circuits» de Mr. Sergio Franco, publié aux éditions McGraw-Hill International.

Ce document préconise de répartir équitablement sur les deux amplificateurs le gain de l'ensemble du dispositif, c'est-à-dire d'attribuer aux gains propres des premier et deuxième amplificateurs des valeurs identiques, de façon à obtenir pour le dispositif la plus large bande passante possible.

Ce document est muet sur les caractéristiques de linéarité du dispositif d'amplification.

Or, dans la plupart des applications dans lesquelles une amplification d'un signal est nécessaire, l'évolution de la valeur du signal amplifié doit être linéaire en fonction de la valeur du signal à amplifier, sous peine de provoquer des distorsions dans le signal amplifié et d'altérer ainsi l'information qu'il véhicule.

La présente invention a pour but d'optimiser les performances en linéarité d'un dispositif d'amplification comportant deux étages, tout en préservant une bande passante acceptable.

Les inventeurs ont en effet découvert que la répartition du gain usuellement préconisée pour optimiser la bande passante n'est pas celle qui permet d'obtenir la meilleure linéarité pour le dispositif d'amplification. Selon leur invention, un dispositif d'amplification conforme au paragraphe introductif est caractérisé en ce que la valeur de l'inverse du gain propre du premier amplificateur est substantiellement égale au triple de la valeur de l'inverse du gain propre du deuxième amplificateur portée au cube.

Il sera démontré dans la suite de l'exposé qu'un tel choix porte à un maximum la valeur de la linéarité du dispositif d'amplification.

Il va de soi que de multiples modes de réalisation des premier et deuxième amplificateurs sont possibles et à la portée de l'homme du métier.

Selon l'un de ces modes de réalisation, chaque amplificateur inclut un amplificateur opérationnel câblé en inverseur.

Selon un autre mode de réalisation, chaque amplificateur inclut un amplificateur opérationnel câblé en non-inverseur.

Dans d'autres modes de réalisation, chaque amplificateur pourra lui-même être constitué d'une pluralité d'amplificateurs disposés en cascade.

L'invention s'inscrit dans un cadre tellement général que d'innombrables applications en sont possibles, comme par exemple l'amplification de signaux au sein de téléviseurs, de boîtiers décodeurs ou encore au sein de radiotéléphones. L'invention concerne donc également un appareil récepteur de signaux radioélectriques, incluant :

- . un système d'antenne pour opérer la réception d'un tel signal et sa transformation en un signal électronique, dit signal radio,
- . un convertisseur de fréquences destiné à fournir un signal intermédiaire représentatif du signal radio, ayant une fréquence dite intermédiaire,
- . un dispositif d'amplification conforme à la revendication 1, destiné à fournir un signal intermédiaire amplifié,
- . un démodulateur destiné à démoduler le signal fourni par le dispositif d'amplification, et
- . une unité de traitement du signal destinée à exploiter le signal démodulé.

L'invention sera mieux comprise à l'aide de la description suivante, faite à titre d'exemple non-limitatif et en regard des dessins annexés, dans lesquels :

- la figure 1 est un schéma de principe décrivant un dispositif d'amplification mettant en oeuvre l'invention,
- la figure 2 est un schéma fonctionnel décrivant un mode de réalisation de l'invention,
- la figure 3 est un schéma fonctionnel décrivant un autre mode de réalisation de l'invention, et
- la figure 4 est une courbe illustrant les variations de la linéarité en fonction du gain du premier amplificateur, et
- la figure 5 est un schéma fonctionnel décrivant un appareil récepteur mettant en oeuvre l'invention.

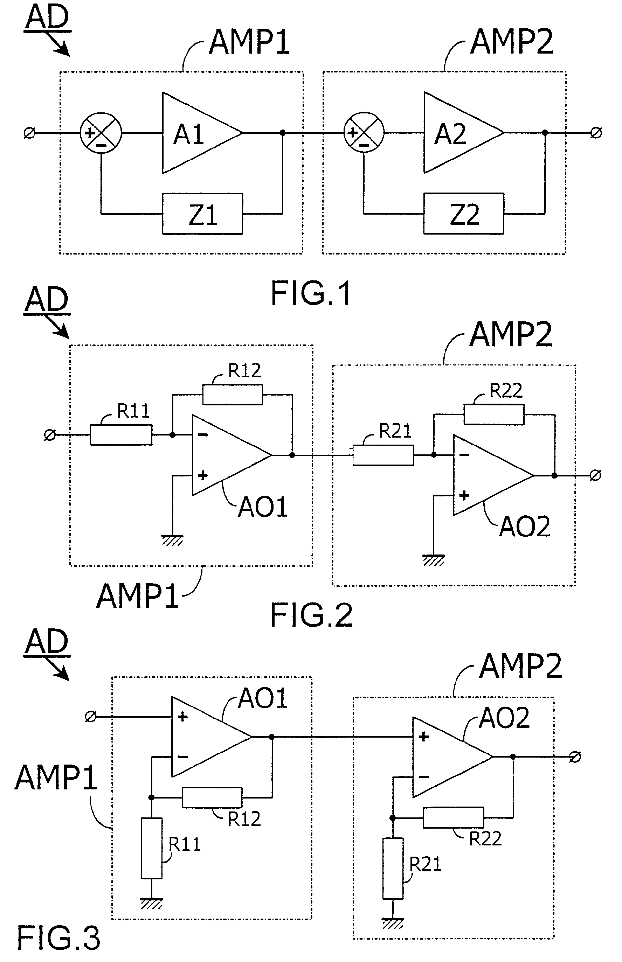

La figure 1 représente schématiquement un dispositif d'amplification AD, incluant un premier et un deuxième amplificateur AMP1 et AMP2 disposés en cascade. Chaque amplificateur AMPi inclut un étage d'amplification possédant un gain $A_i$ et est muni d'une boucle de rétro-action possédant un gain de boucle $Z_i$. Chaque amplificateur AMPi possède donc un gain propre $G_i$ égal à $A_i/(1+A_i.Z_i)$, défini comme le rapport entre les amplitudes de signaux de sortie et d'entrée de cet amplificateur AMPi.

D'après les travaux des inventeurs, la linéarité LIN du dispositif d'amplification AD peut être extraite de la formule suivante :

$$(1/LIN)^2=(1/LIN1)^2+(G1/LIN2)^2,$$

où $LIN_i$ est la linéarité du ième amplificateur et peut être exprimée sous la forme $LIN_i=(LINA_i).(A_i.Z_i)^{3/2}$, $LINA_i$ étant la linéarité de l'étage d'amplification inclus dans l'amplificateur $A_i$.

Si les étages d'amplification des premier et deuxième amplificateurs sont semblables et possèdent un même gain propre égal à A dont la valeur est grande devant celles des gains de boucle Z1 et Z2, c'est-à-dire que le gain propre Gi de chaque amplificateur AMPi est équivalent à 1/Zi, il découle de ce qui précède que :

$$(1/LIN)^2=(1/LINA^2.A^3).[(1/Z1^3)+(G1^2/Z2^3)].$$

Si l'on pose $Z=Z1.Z2$, on obtient $LIN^2=K.[(Z1^3.Z^3)/(Z1^4+Z^3)]$, où K est une constante sans incidence sur la démonstration.

Le gain du dispositif d'amplification étant fixé lors de la conception dudit dispositif, la dérivée par rapport à Z1 de l'expression précédente s'écrit $(K/D).Z.Z1^2.[3.Z^3-Z1^4]$, D représentant un dénominateur dont la valeur est toujours positive.

La dérivée définie ci-dessus est positive si $Z1<(3.Z^3)^{1/4}$ et est négative si $Z1>(3.Z^3)^{1/4}$. A la valeur $Z1=(3.Z^3)^{1/4}$ correspond donc un maximum de la linéarité LIN du dispositif d'amplification, soit encore $Z1=3.(Z2)^3$, ou $(1/G1)=3/(G2)^3$.

Le dispositif d'amplification AD présentera donc une linéarité optimale si l'on choisit pour la valeur de l'inverse du gain propre G1 du premier amplificateur AMP1 le triple de la valeur de l'inverse du gain propre G2 du deuxième amplificateur AMP2 portée au cube.

A titre d'exemple, si l'on impose 20dB comme valeur du gain total du dispositif d'amplification AD, cela signifie que G1.G2=10, et donc Z=Z1.Z2=0,1, en tenant compte des hypothèses précédentes.

Le maximum de la linéarité LIN du dispositif d'amplification AD est obtenu pour Z1=0,234, ce qui implique que Z2=0,427. La valeur du gain G1 du premier amplificateur AMP1 sera donc voisine de 4,27, tandis que la valeur du gain G2 du deuxième amplificateur AMP2 sera voisine de 2,34.

Dans le dispositif connu où l'on préconise une répartition équitable du gain total du dispositif sur les deux amplificateurs AMP1 et AMP2, la valeur du gain de chacun de ces amplificateurs aurait été voisine de 3,33, ce qui n'aurait pas permis d'obtenir la meilleure linéarité possible pour le dispositif d'amplification.

On constate cependant que les valeurs des gains des premier et deuxième amplificateurs AMP1 et AMP2 préconisées selon la présente invention sont suffisamment voisines de celles préconisées dans les dispositifs connus pour que la largeur de la bande passante du dispositif conforme à l'invention soit acceptable.

La figure 2 est un schéma fonctionnel qui représente un mode de réalisation d'un dispositif d'amplification AD selon l'invention. Dans ce mode de réalisation, chaque amplificateur AMPi inclut un amplificateur opérationnel AOi câblé en inverseur :

Chaque amplificateur opérationnel AOi présente en effet une borne d'entrée non-inverseuse, reliée à une borne de référence de potentiel, constituée ici une masse, une borne d'entrée inverseuse reliée à une entrée de l'amplificateur AMPi via une première résistance Ri1, et à une borne de sortie de l'amplificateur AMPi, formée

par une sortie de l'amplificateur opérationnel AOi, via une deuxième résistance Ri2.

Il est connu que la valeur absolue du gain propre Gi de chaque amplificateur AMPi conforme à ce mode de réalisation s'écrit Ri2/Ri1. Pour reprendre l'exemple décrit précédemment, on choisira selon l'invention les rapports suivants pour obtenir une linéarité optimale pour le dispositif d'amplification AD :

$$R12/R11=4,27,$$

et

$$R22/R21=2,34.$$

La figure 3 est un schéma fonctionnel qui représente un autre mode de réalisation d'un dispositif d'amplification AD selon l'invention. Dans ce mode de réalisation, chaque amplificateur AMPi inclut un amplificateur opérationnel AOi câblé en non-inverseur :

Chaque amplificateur opérationnel AOi présente en effet une borne d'entrée non-inverseuse formant une entrée de l'amplificateur AMPi, une borne d'entrée inverseuse reliée à une borne de référence de potentiel, constituée ici une masse, via une première résistance Ri1 et à une borne de sortie de l'amplificateur AMPi, formée par une sortie de l'amplificateur opérationnel AOi, via une deuxième résistance Ri2.

Il est connu que le gain propre Gi de chaque amplificateur AMPi conforme à ce mode de réalisation s'écrit 1+(Ri2/Ri1). Pour reprendre l'exemple décrit plus haut, on choisira selon l'invention les rapports suivants pour obtenir une linéarité optimale pour le dispositif d'amplification AD :

$$R12/R11=3,27,$$

et

$$R22/R21=1,34.$$

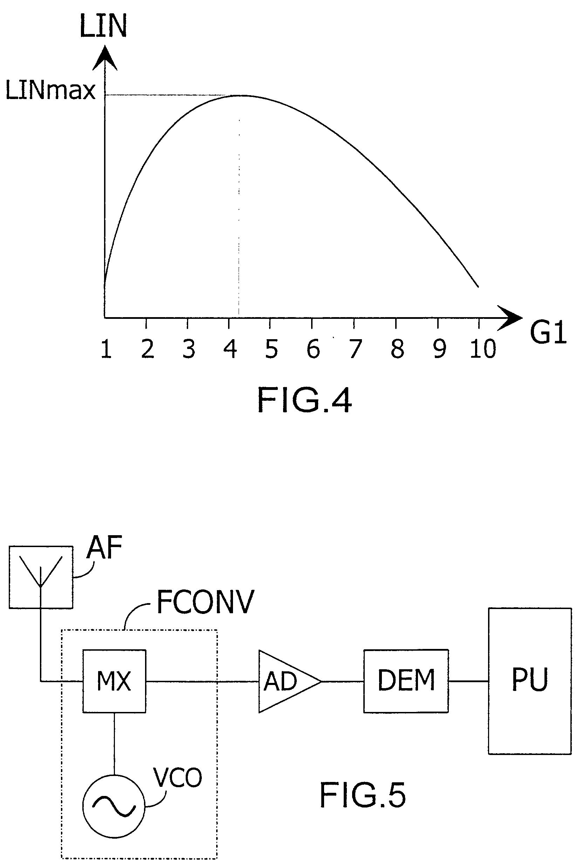

La figure 4 illustre les variations de la linéarité LIN du dispositif d'amplification décrit par la figure 1, en fonction des variations du gain propre G1 du premier amplificateur AMP1.

Cette courbe a la forme d'une cloche asymétrique présentant un maximum pour G1=4,27 dans le cas illustré ici où le gain total du dispositif d'amplification est fixé à 20dB, soit 0<G1<10.

La figure 5 illustre l'un des nombreux modes de mise en oeuvre possibles de l'invention. Cette figure représente un appareil récepteur de signaux radioélectriques, incluant :

- un système d'antenne AF pour opérer la réception d'un tel signal et sa transformation en un signal électronique, dit signal radio,
- un convertisseur de fréquences FCONV destiné à fournir un signal intermédiaire représentatif du signal radio, ayant une fréquence dite intermédiaire,
- un dispositif d'amplification AD tel que décrit plus haut, destiné à fournir un signal intermédiaire amplifié,
- un démodulateur DEM destiné à démoduler le signal fourni par le dispositif d'amplification AD, et
- une unité de traitement du signal PU destinée à exploiter le signal démodulé.

L'utilisation d'un dispositif d'amplification AD conforme à l'invention permet d'assurer que les signaux reçus par l'unité de traitement du signal PU seront exempts de toute distorsion, et que l'unité PU en extraira des informations conformes à celles initialement transmises.

**Revendications**

1. Dispositif d'amplification incluant un premier et un deuxième amplificateur disposés en cascade, chacun possédant un gain propre et étant muni d'une boucle de rétro-action, dispositif dans lequel la valeur de l'inverse du gain propre du premier amplificateur est substantiellement égale au triple de la valeur de l'inverse du gain propre du deuxième amplificateur portée au cube.

2. Dispositif d'amplification selon la revendication 1, dans lequel chaque amplificateur inclut un amplificateur opérationnel câblé en inverseur.

3. Dispositif d'amplification selon la revendication 1, dans lequel chaque amplificateur inclut un amplificateur opérationnel câblé en non-inverseur.

4. Appareil récepteur de signaux radioélectriques, incluant :

   - un système d'antenne pour opérer la réception d'un tel signal et sa transformation en un signal électronique, dit signal radio,
   - un convertisseur de fréquences destiné à fournir un signal intermédiaire représentatif du signal radio, ayant une fréquence dite intermédiaire,
   - un dispositif d'amplification conforme à la revendication 1, destiné à fournir un signal intermédiaire amplifié,
   - un démodulateur destiné à démoduler le signal fourni par le dispositif d'amplification, et
   - une unité de traitement du signal destinée à exploiter le signal démodulé.

AD

AMP1

AMP2

A1

Z1

A2

Z2

FIG.1

AD

AMP1

AMP2

R11

R12

AO1

R21

R22

AO2

FIG.2

AD

AMP1

AMP2

AO1

AO2

R11

R12

R21

R22

FIG.3

FIG.4

FIG.5

Office européen
des brevets

**RAPPORT DE RECHERCHE EUROPEENNE**

Numéro de la demande

EP 01 20 3280

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | WO 00 16475 A (GEN INSTRUMENT CORP) 23 mars 2000 (2000-03-23) * page 18, ligne 11 - ligne 19; figure 2 * | 1 | H03F1/32 H03F3/60 H03F3/68 |
| A | US 4 320 351 A (BROWN JR FLOYD A ET AL) 16 mars 1982 (1982-03-16) * figure 1 * | 1 | |

**DOMAINES TECHNIQUES RECHERCHES (Int.Cl.7)**

H03F

Le présent rapport a été établi pour toutes les revendications

| Lieu de la recherche | Date d'achèvement de la recherche | Examinateur |
|---|---|---|
| LA HAYE | 11 décembre 2001 | Segaert, P |

## ANNEXE AU RAPPORT DE RECHERCHE EUROPEENNE
## RELATIF A LA DEMANDE DE BREVET EUROPEEN NO.

EP 01 20 3280

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-12-2001

| Document brevet cité au rapport de recherche | | Date de publication | Membre(s) de la famille de brevet(s) | | Date de publication |
|---|---|---|---|---|---|
| WO 0016475 | A | 23-03-2000 | US | 6133790 A | 17-10-2000 |
| | | | AU | 5814099 A | 03-04-2000 |
| | | | BR | 9913778 A | 10-07-2001 |
| | | | EP | 1119905 A1 | 01-08-2001 |
| | | | WO | 0016475 A1 | 23-03-2000 |
| | | | US | 6232836 B1 | 15-05-2001 |
| US 4320351 | A | 16-03-1982 | AUCUN | | |

EPO FORM P0460

Pour tout renseignement concernant cette annexe : voir Journal Officiel de l'Office européen des brevets, No.12/82